Europäisches Patentamt

European Patent Office

Office européen des brevets

(11) Numéro de publication : **0 576 341 A1**

(19)

# (12) DEMANDE DE BREVET EUROPEEN

(21) Numéro de dépôt : **93401591.8**

(22) Date de dépôt : **22.06.93**

(51) Int. Cl.$^5$ : **H03F 1/32**

(30) Priorité : **26.06.92 FR 9207890**

(43) Date de publication de la demande :
**29.12.93 Bulletin 93/52**

(84) Etats contractants désignés :
**CH DE ES FR GB GR IT LI NL PT SE**

(71) Demandeur : **THOMSON-LGT LABORATOIRE GENERAL DES TELECOMMUNICATIONS**
**1, rue de l'Hautil**
**F-78700 Conflans-Sainte Honorine (FR)**

(72) Inventeur : **Michel, Jean**
**THOMSON-CSF, SCPI, BP 329**
**F-92402 Courbevoie Cédex (FR)**

(74) Mandataire : **Courtellemont, Alain et al**
**THOMSON-CSF, SCPI, B.P. 329, 50, rue**
**Jean-Pierre Timbaud**
**F-92402 Courbevoie Cédex (FR)**

(54) **Dispositif d'amplification de puissance d'un signal composite.**

(57) L'invention concerne l'amplification linéaire de puissance, dans une voie unique, d'un signal composite (Ve) formé de deux signaux indépendants.

Dans une voie unique formée de moyens de correction, suivis d'un préamplificateur linéaire, suivi d'un amplificateur saturé, l'effet de filtrage et de symétrie produit, aussi bien dans les moyens de correction que dans l'amplificateur, est mis à profit pour compenser l'écrêtage dû à l'amplificateur ; cela permet d'obtenir des signaux de sortie non distordus dont l'amplitude dépasse le niveau de saturation de l'amplificateur. La compensation nécessite que la caractéristique de transfert des moyens de correction (C1) ait une pente donnée entre deux points au delà desquels la saturation apparaît dans l'amplificateur et une pente sensiblement triple de la pente donnée de part et d'autre de ces deux points.

Application, en particulier, à la télévision.

FIG.7

EP 0 576 341 A1

La présente invention est relative à l'amplification de puissance d'un signal composite et plus précisément à son amplification linéaire.

Par signal composite il faut comprendre un signal fait d'un premier et d'un second signal indépendants l'un de l'autre, étant entendu que chacun des deux signaux indépendants peut lui-même être un signal composite.

Il est connu, par exemple en télévision, d'effectuer une amplification linéaire de puissance d'un signal composite formé du signal image et du signal son ; c'est l'amplification à voie unique par opposition à l'amplification à voies séparées où, par exemple en télévision, les signaux image et son sont amplifiés par deux voies distinctes.

Pour effectuer une amplification linéaire à voie unique il est connu d'utiliser un amplificateur de sortie jusqu'à et non compris sa zone de saturation, en lui associant un amplificateur complémentaire ; l'amplificateur complémentaire est placé en série devant l'amplificateur de sortie et sa caractéristique de transfert est choisie de manière à être complémentaire de celle de l'amplificateur de sortie c'est-à-dire de manière que la caractéristique de transfert de ces deux amplificateurs soit une droite entre deux points dits points de saturation représentant respectivement les limites d'amplification linéaire d'un signal positif et d'un signal négatif ; au delà de ces points le gain de l'ensemble constitué par les deux amplificateurs est nul ou quasi-nul.

En considérant comme premier signal indépendant le signal de plus forte amplitude, le second signal a pour effet de déplacer le premier de part et d'autre de la position qu'il occuperait s'il était seul ; cela fait que, en donnant la valeur 1 à l'amplitude crête du premier signal, le signal composite oscille entre deux valeurs limites 1 + D et -1-D, où D est la valeur maximale de déplacement.

Les dispositifs d'amplification linéaire connus comportent, en série, l'amplificateur complémentaire, un préamplificateur et l'amplificateur de sortie ; afin de conserver la linéarité d'amplification les puissances du préamplificateur et de l'amplificateur de sortie sont augmentées d'un coefficient $(1 + D)^2$ par rapport à ce qui est nécessaire pour amplifier linéairement le premier signal indépendant seul.

Si l'augmentation de la puissance du préamplificateur est relativement peu onéreuse, il n'en va pas de même pour l'amplificateur de sortie quand les puissances de sortie se chiffrent en dizaines voire en centaines de kilowatts.

Le but de la présente invention est de réduire la puissance nécessaire à l'amplificateur de sortie tout en maintenant la linéarité d'amplification.

Ceci est obtenu en modifiant, par rapport aux dispositifs connus, les caractéristiques des circuits qui précédent l'amplificateur de sortie.

Selon l'invention il est proposé à cet effet un dispositif d'amplification pour effectuer une amplification linéaire de puissance d'un signal d'entrée composite formé d'un premier et d'un second signal indépendants l'un de l'autre et où le second signal a un niveau maximum au plus égal à celui du premier, comportant des moyens de correction suivis d'un préamplificateur suivi d'un amplificateur saturé , et ayant une caractéristique de transfert sensiblement linéairement continue entre deux points dits points de saturation et sensiblement constante de part et d'autre de ces deux points, caractérisé en ce que, afin que l'amplitude crête à crête du premier signal à la sortie du dispositif puisse atteindre la valeur de la différence de tension entre les deux points de saturation, l'ensemble d'entrée constitué par les moyens de correction et le préamplificateur a une caractéristique de transfert dont la courbe, en ne tenant pas compte de l'effet de filtrage propre à cet ensemble d'entrée, présente, entre deux points particuliers correspondant aux points de saturation dans l'amplification par l'amplificateur saturé, une pente donnée et une pente sensiblement triple de la pente donnée de part et d'autre des deux points particuliers.

La présente invention sera mieux comprise et d'autres caractéristiques apparaîtront à l'aide de la description ci-après et des figures s'y rapportant qui représentent :

- la figure 1, le schéma simplifié d'un dispositif d'amplification linéaire de puissance,
  la figure 2, les caractéristiques de transfert de deux amplificateurs complémentaires,
- les figures 3 et 4, respectivement la caractéristique de transfert et le schéma d'un amplificateur complémentaire,
- la figure 5, les formes de signaux relatifs à un amplificateur complémentaire,
- les figures 6 et 7, des schémas montrant l'évolution de signaux au fur et à mesure de leur progression dans, respectivement, un dispositif selon l'art connu et un dispositif selon l'invention.

La description qui suit est faite dans le cadre de l'amplification à voie unique d'un signal composite de télévision, formé d'un signal image et d'un signal son ; l'homme du métier pourra sans peine l'adapter à l'amplification d'autres signaux composites.

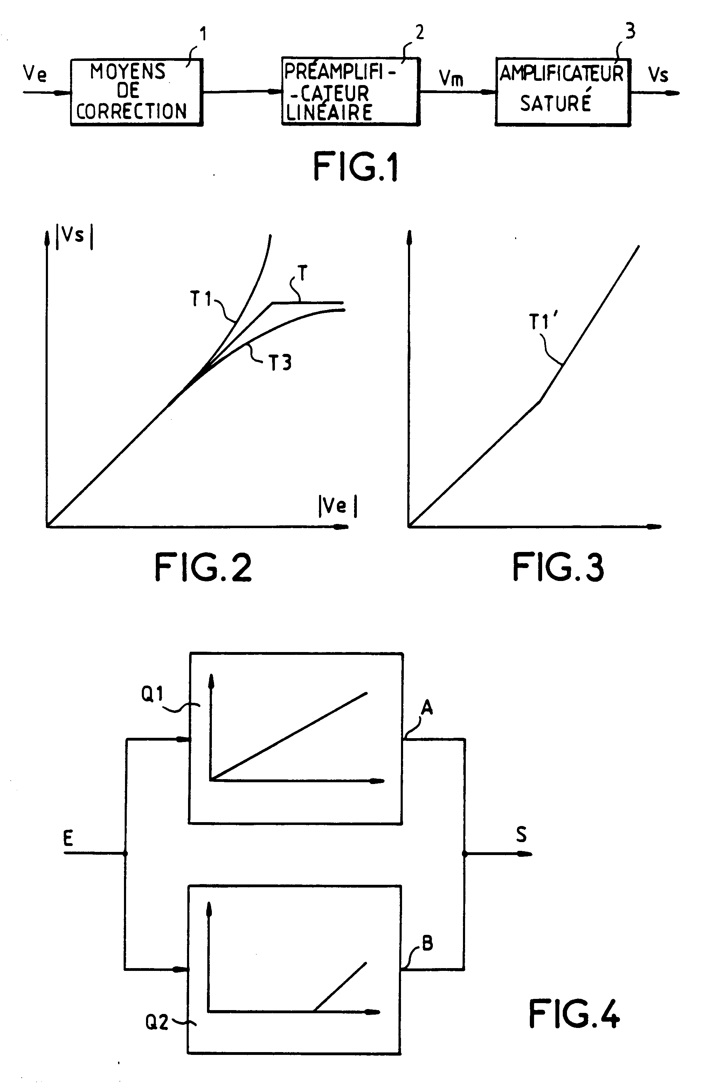

La figure 1 représente un dispositif d'amplification linéaire, à voie unique, constitué de trois circuits en série : des moyens de correction 1 qui reçoivent un signal Ve, suivis d'un préamplificateur linéaire 2, lui-même suivi d'un amplificateur saturé qui délivre un signal Vs correspondant au signal Ve amplifié linéairement.

Dans les dispositifs d'amplification linéaire selon l'art connu les moyens de correction 1 ont simplement à présenter une caractéristique de transfert telle que la caractéristique de transfert du dispositif soit une droite jusqu'au niveau de saturation de l'amplificateur de sortie.

La figure 2 montre la courbe T représentative de la caractéristique de transfert du dispositif selon la figure 1 avec en abscisse les valeurs absolues de la tension d'entrée Ve et en ordonnées les valeurs absolues de la tension de sortie Vs ; cette caractéristique de transfert est obtenue par deux amplificateurs complémentaires placés en série : les moyens de correction 1 et l'amplificateur saturé 3 dont les gains en tension sont donnés respectivement par les pentes d'une courbe T1 et d'une courbe T3. Le produit de ces gains est gardé constant jusqu'à et non comprise la zone de saturation de l'amplificateur saturé, pour avoir une amplification linéaire ; dans la zone de saturation le gain de l'amplificateur saturé tendant vers zéro il faudrait que le gain des moyens de correction tende vers l'infini pour garder la linéarité d'amplification, ce qui est impossible ; la courbe T présente donc une partie de pente constante non nulle, suivie d'une partie de pente nulle au delà d'un point correspondant au début de la saturation de l'amplificateur de sortie 3.

En réalité la courbe T1 n'a pas exactement la forme complémentaire de la courbe T3 représentée sur la figure 2, car elle est obtenue par approximation de cette forme complémentaire au moyen d'une ligne brisée formée de segments de droites. Un telle ligne brisée, Tl', est représentée sur la figure 3. Pour simplifier les explications la courbe selon la figure 3 ne comporte que deux segments de droite.

La caractéristique de transfert selon la courbe de la figure 3 est obtenue par un montage représenté sur la figure 4 ; ce montage est constitué par la mise en parallèle de deux quadripôles Q1, Q2 dont l'un, Q1, est linéaire c'est-à-dire fonctionne en classe A et dont l'autre, Q2, a un état bloqué suivi d'un état passant linéaire, c'est-à-dire fonctionne en classe C. Ces deux quadripôles reçoivent le même signal sur leur entrée commune E et ont leurs sorties respectives A et B reliées à une même sortie commune S.

La suite de la description va se rapporter, à titre d'exemple non limitatif, à l'amplification d'un signal composite de télévision formé d'un signal image et d'un signal son et ce signal composite sera représenté sur les figures par son enveloppe.

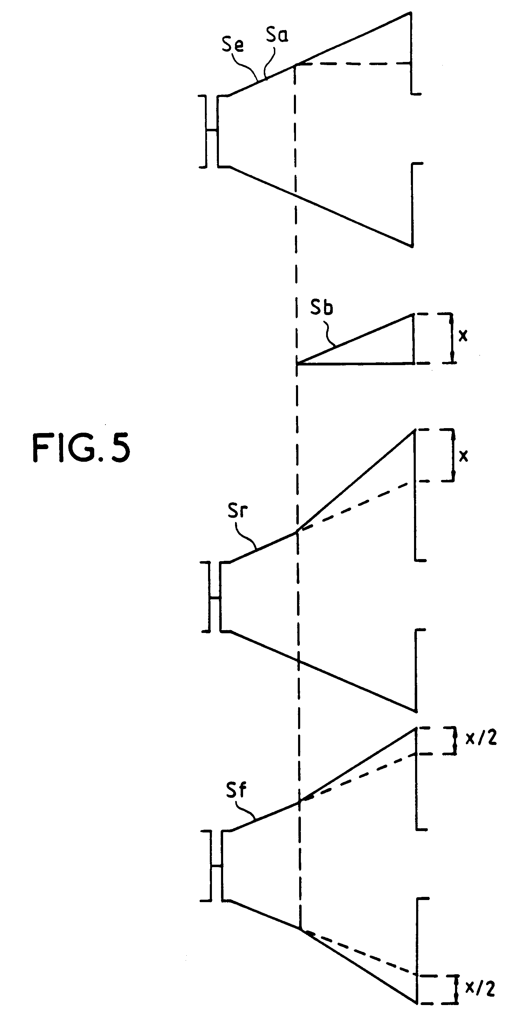

La figure 5 montre quatre signaux Se, Sb, Sr et Sf. Le signal Se est le signal image de télévision ; il est appliqué à l'entrée E du montage selon la figure 4 et ce même signal se retrouve sur la sortie A du quadripôle Q1, à l'amplification linéaire près de ce quadripôle. Le signal Sb est le signal sur la sortie B du quadripôle Q2 ; l'amplitude maximum du signal Sb est notée x sur la figure.

La forme du signal au point S du montage selon la figure 4 diffère en fonction de la façon dont s'effectue la sommation des signaux fournis par les quadripôles Q1 et Q2. Si le montage est à large bande et donne donc les résultats d'une sommation dans une résistance, le signal à la sortie S est représenté par le signal Sr de la figure 5, c'est un signal qui a perdu la symétrie du signal d'entrée Se du fait de la sommation réalisée.

La symétrie peut être retrouvée en appliquant le signal Sr à l'entrée d'un filtre. En effet le signal Se sur l'entrée E du montage selon la figure 4 étant un signal modulé par un signal vidéo en dents de scie, le spectre du signal Sr se compose du spectre fondamental du signal modulé Se, d'harmoniques et surtout du spectre du signal modulant régénéré par la non linéarité du montage, la suppression du spectre modulant peut se faire par filtrage du spectre fondamental dans ce signal Sr ; ce filtrage donne le signal Sf de la figure 5.

Il est à noter que, dans les amplificateurs en radio-fréquences, dont le modèle est également l'association de deux quadripôles selon la figure 4, il n'est pas possible de trouver un signal du type du signal Sr de la figure 5 car la charge et le filtrage y sont intimement liés. En effet les circuits d'adaptation de sortie de ces amplificateurs sont des transformateurs d'impédance de bande passante suffisante pour satisfaire aux exigences du spectre fondamental, mais les limites de cette bande passante éliminent naturellement le spectre modulant et les harmoniques.

Le signal Sf selon la figure 5 est un signal symétrique, néanmoins il ne reproduit pas la forme du signal d'entrée Se ; c'est-à-dire que l'amplification n'est pas linéaire. Pour éviter cette non linéarité il est connu de ne faire travailler l'amplificateur saturé et les moyens de correction que dans la partie rectiligne de leur caractéristique de transfert qui passe par le point zéro du graphique.

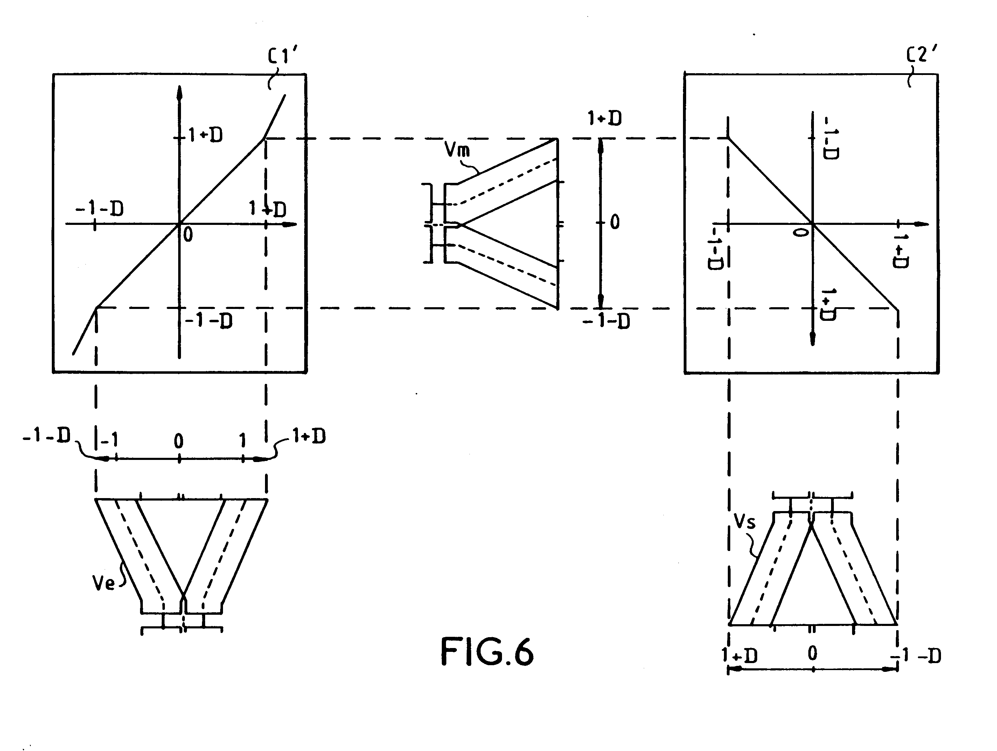

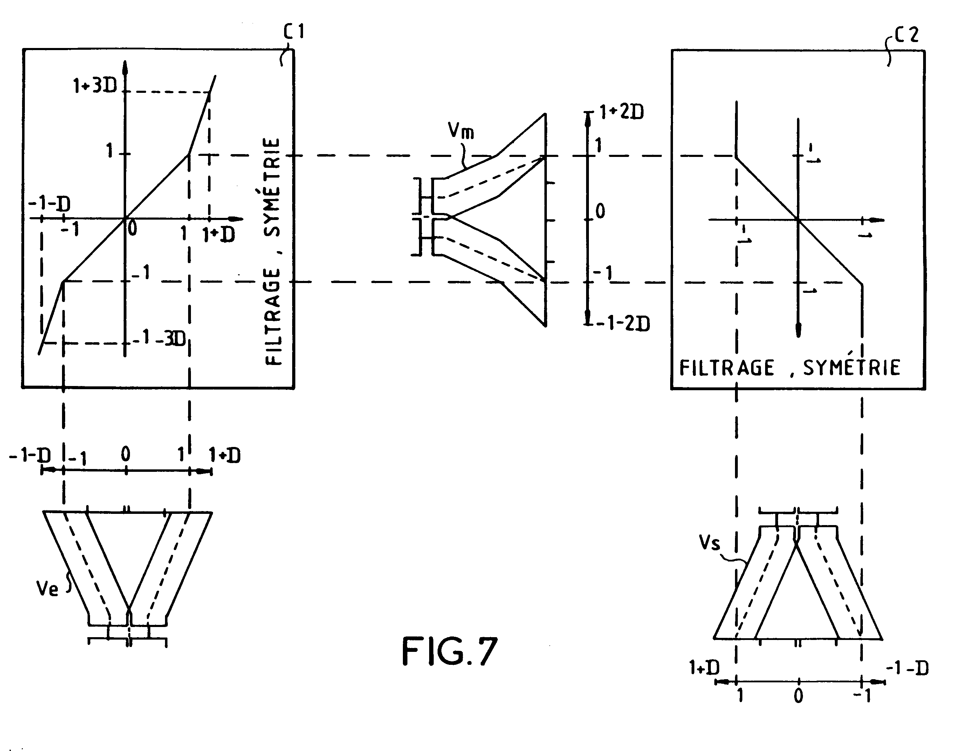

Cette technique connue est illustrée à l'aide de la figure 6 où le signal d'entrée Ve du dispositif selon la figure 1 est représenté en traits continus dans les positions extrêmes qu'il occupe et en traits interrompus dans sa position moyenne ; la position moyenne correspond au signal image seule ; le signal son déplace le signal image dans un mouvement sinusoïdal d'amplitude D où, en donnant à l'amplitude de l'enveloppe du signal image la valeur 1, la valeur D est égale au rapport du niveau image sur le niveau son. Sur la figure 6, ainsi que sur la figure 7 et dans ce qui suit, les valeurs 1 et D correspondent à des amplitudes en des points donnés du dispositif d'amplification et, par exemple, la valeur 1 est attribuée à l'amplitude du signal image seul aussi bien à l'entrée, qu'à la sortie, qu'en tout autre point du dispositif ; étant entendu que, par exemple, la valeur 1 + D du signal de sortie du dispositif ne correspond à la valeur 1 + D du signal d'entrée qu'à l'amplification près du dispositif.

Quel que soit le déplacement, c'est-à-dire même pour les valeurs extrêmes, le signal composite est toujours amplifié dans la partie linéaire de la caractéristique de l'amplificateur, qu'il s'agisse des moyens de correction ou de l'amplificateur saturé, étant entendu que, par définition, il en est de même dans le préamplificateur linéaire 2 selon la figure 1. Ainsi selon la figure 6, le signal d'entrée Ve subit une première amplification linéaire, selon une caractéristique de transfert C1' pour donner un signal Vm qui subit une seconde amplification linéaire, selon une caractéristique de transfert C2', dans l'amplificateur saturé, pour donner le signal de sortie Vs. Sur la figure 6, comme sur la figure 7, pour simplifier la compréhension, la caractéristique de l'amplificateur saturé est dessinée comme si elle n'avait pas besoin de correction ; cela ne change rien aux explications données, la forme des caractéristiques de transfert représentées étant seulement légèrement modifiées par rapport à la réalité et les différences de forme se compensant entre les caractéristiques de transfert de la première et de la seconde amplification.

Comme il apparaît sur la figure 6, en raison du déplacement D le dispositif d'amplification doit fournir une puissance de sortie qui est multipliée par $(1 + D)^2$ par rapport à ce qui est nécessaire pour amplifier le signal image seul, et la puissance de sortie crête, Pc, du signal composite est égale à la puissance de saturation, Psat, de l'amplificateur :

$$Pc = Psat.$$

La figure 7 montre comment le dispositif peut être modifié pour obtenir

$$Pc = n.Psat$$

où n appartient à l'ensemble des réels et où $1 < n \leq 4$

Cela est obtenu en mettant à profit les effets associés de filtrage et de symétrie dont il a été question plus avant, en particulier lors de la description de la figure 5. Aussi bien en ce qui concerne la première amplification, c'est-à-dire avant l'amplificateur saturé, que la seconde par l'amplificateur saturé, la modification consiste à accepter, sous certaines conditions, de travailler au delà du coude des caractéristiques de transfert.

Si l'amplificateur saturé est utilisé au delà de la saturation une partie du signal va être écrêtée du fait de la saturation mais pourra être régénérée par l'effet de filtrage et de symétrie, sous deux conditions :

1° que, au plus, la moitié du signal soit écrêtée lorsque le déplacement est maximum,

2° que la partie du signal qui est écrêtée soit exactement reconstituée par filtrage et symétrie.

La première condition est satisfaite avec une tension de saturation, Vsat, un déplacement, D, et une amplitude, 1, du signal image seul, égales :

$$Vsat = D = 1$$

avec ici encore la valeur 1 attribuée à l'amplitude maximale du signal image seul.

La seconde condition nécessite que, dans la caractéristique de transfert de la première amplification, c'est-à-dire de l'amplification autre que celle de l'amplificateur saturé, la pente soit triplée au delà des points (1, 1) (-1, -1) par rapport à ce qu'elle est entre ces points.

Comme il apparaissait sur la figure 6, le signal d'entrée Ve subissait une première amplification linéaire pour des valeurs comprises entre -1 -D et 1 + D c'est-à-dire pour toutes les valeurs de ce signal quel que soit le déplacement dû au signal son. Le signal Vm obtenu par cette première amplification subissait, pour fournir le signal de sortie Vs, une seconde amplification ; cette seconde amplification obtenue grâce à l'amplificateur saturé était linéaire pour toutes les valeurs de ce signal Vm comprises entre -1 -D et 1 + D, c'est-à-dire pour toutes les valeurs du signal Vm quel que soit le déplacement occasionné par le signal son.

Comme le montre la figure 7 qui se rapporte à l'invention, les première et seconde amplifications ne sont plus linéaires dans toute la plage des tensions à amplifier. Le signal Ve subit une première amplification, selon une caractéristique de transfert C1, qui est linéaire pour les valeurs de Ve comprises entre -1 et +1 mais qui ensuite présente un coude avec une pente triple de ce qu'elle était entre -1 et +1 ; et, par exemple pour le déplacement +D où les tensions maximale et minimale du signal Ve sont respectivement 1 + D et -1 +D, les valeurs maximale et minimale correspondante du signal Vm qui seraient respectivement de 1 + 3D et -1 +D sans l'effet de filtrage et de symétrie, sont de 1 + 2D et -1. Quant au signal Vm il subit la seconde amplification, selon une caractéristique de transfert C2, qui est linéaire pour les valeurs de Vm comprises entre -1 et +1 et qui est de gain nul, du fait de la saturation, pour toutes les valeurs de Vm supérieures à 1 en valeur absolue. Et, bien que le signal Vm ait été distordu et ait subi l'effet de filtrage et symétrie, pour ses valeurs comprises entre 1 et 1 + 2D et entre -1 et -1 -2D, lors de la première amplification, le signal Vs à la sortie de l'amplificateur saturé se présente comme si le signal Ve avait subi une amplification linéaire tout au long de la voie unique que constitue le dispositif ; comme il a été indiqué précédemment cela est dû à l'effet de filtrage et de symétrie de l'amplificateur saturé et à l'effet de compensation obtenu dans ce qui a été appelé la première amplification.

## Revendications

1. Dispositif d'amplification pour effectuer une amplification linéaire de puissance d'un signal d'entrée composite (Ve) formé d'un premier et d'un second signal indépendants l'un de l'autre et où le second signal a un niveau maximum au plus égal à celui du premier, comportant des moyens de correction (1) suivis d'un préamplificateur (2) suivi d'un amplificateur saturé (3), et ayant une caractéristique de transfert sensiblement linéairement continue entre deux points dits points de saturation et sensiblement constante de part et d'autre de ces deux points, caractérisé en ce que, afin que l'amplitude crête à crête du premier signal à la sortie du dispositif puisse atteindre la valeur de la différence de tension entre les deux points de saturation, l'ensemble d'entrée constitué par les moyens de correction (1) et le préamplificateur (2) a une caractéristique de transfert (C1) dont la courbe, en ne tenant pas compte de l'effet de filtrage propre à cet ensemble d'entrée, présente, entre deux points particuliers correspondant aux points de saturation dans l'amplification par l'amplificateur saturé, une pente donnée et une pente sensiblement triple de la pente donnée de part et d'autre des deux points particuliers.

FIG.1

FIG.2

FIG.3

FIG.4

FIG.5

FIG.6

EP 0 576 341 A1

FIG.7

EP 0 576 341 A1

**Office européen des brevets**

# RAPPORT DE RECHERCHE EUROPEENNE

Numero de la demande

EP 93 40 1591

## DOCUMENTS CONSIDERES COMME PERTINENTS

| Catégorie | Citation du document avec indication, en cas de besoin, des parties pertinentes | Revendication concernée | CLASSEMENT DE LA DEMANDE (Int. Cl.5) |
|---|---|---|---|
| Y | EP-A-0 040 127 (L.G.T. LABORATOIRE GENERAL DES TELECOMMUNICATIONS) <br> * le document en entier * <br> --- | 1 | H03F1/32 |
| Y | EP-A-0 190 073 (THOMSON-CSF) <br> * le document en entier * <br> --- | 1 | |
| A | 16TH EUROPEAN MICROWAVE CONFERENCE pages 810 - 815 '8th to 12th September 1986, Dublin Ireland. Published by Microwave exhibitions and publishers Ltd., 1986, Tunbridge Wells (GB). Conference proceedings. J. Czech : "A linearized L-Band 200 watt twt amplifier for multicarrier operation."' <br> * le document en entier * <br><br> ----- | 1 | |
| | | | **DOMAINES TECHNIQUES RECHERCHES (Int. Cl.5 )** <br><br> H03F <br> H03G |

Le présent rapport a été établi pour toutes les revendications

| Lieu de la recherche | Date d'achèvement de la recherche | Examinateur |
|---|---|---|
| LA HAYE | 09 SEPTEMBRE 1993 | DECONINCK E. |

CATEGORIE DES DOCUMENTS CITES

X : particulièrement pertinent à lui seul
Y : particulièrement pertinent en combinaison avec un autre document de la même catégorie
A : arrière-plan technologique
O : divulgation non-écrite
P : document intercalaire

T : théorie ou principe à la base de l'invention
E : document de brevet antérieur, mais publié à la date de dépôt ou après cette date
D : cité dans la demande
L : cité pour d'autres raisons

  & : membre de la même famille, document correspondant

EPO FORM 1503 03.82 (P0402)

10